(19) Europäisches Patentamt
European Patent Office
Office européen des brevets

(11) **EP 3 798 610 A1**

(12) **EUROPÄISCHE PATENTANMELDUNG**

(43) Veröffentlichungstag:
**31.03.2021  Patentblatt 2021/13**

(51) Int Cl.:
**G01N 21/39** *(2006.01)*       **G01N 21/3504** *(2014.01)*
**G01J 3/433** *(2006.01)*        **H01S 5/042** *(2006.01)*

(21) Anmeldenummer: **19199255.1**

(22) Anmeldetag: **24.09.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder: **Steinbacher, Franz**
**76137 Karlsruhe (DE)**

(54) **GASANALYSATOR MIT EINER WELLENLÄNGENABSTIMMBAREN LASERDIODE**

(57)     Gasanalysator zur Messung der Konzentration einer Gaskomponente in einem Messgas
- mit einer wellenlängenabstimmbaren Laserdiode (D1), deren Licht (2) nach Durchstrahlen des Messgases auf einen Detektor fällt, und
- mit einem Treiber (6), der die Laserdiode (1) zur wellenlängenabhängigen Abtastung einer interessierenden Absorptionslinie der Gaskomponente mit einem periodischen rampenförmigen Strom (i) ansteuert,

dadurch gekennzeichnet,
- dass der Treiber (6) einen Kondensator (C1) enthält, der in Reihe mit einem steuerbaren Schalter (T1) an einer Spannungsquelle (15) liegt und an dem parallel die Laserdiode (D1) in Reihe mit einem Vorwiderstand (R2) liegt, und
- dass der steuerbare Schalter (T1) steuerseitig an einem eine Impulsfolge (8) erzeugenden Impulsgenerator (7) angeschlossen ist.

FIG 2

EP 3 798 610 A1

**Beschreibung**

Die Erfindung betrifft einen Gasanalysator zur Messung der Konzentration einer Gaskomponente in einem Messgas

- mit einer wellenlängenabstimmbaren Laserdiode, deren Licht nach Durchstrahlen des Messgases auf einen Detektor fällt, und
- mit einem Treiber, der die Laserdiode zur wellenlängenabhängigen Abtastung einer interessierenden Absorptionslinie der Gaskomponente mit einem periodischen rampenförmigen Stromsignal ansteuert.

Laserspektrometer werden insbesondere für die optische Gasanalyse in der Prozessmesstechnik eingesetzt. Dabei erzeugt eine Laserdiode Licht im Infrarotbereich, das entlang einer Messstrecke in einer Prozessanlage oder einer Gaszelle durch ein Prozessgas (Messgas) geführt und anschließend detektiert wird. Die Wellenlänge des Lichts wird auf eine spezifische Absorptionslinie der jeweils zu messenden Gaskomponente abgestimmt, wobei die Laserdiode die Absorptionslinie periodisch wellenlängenabhängig abtastet. Dazu wird die Laserdiode innerhalb von aufeinanderfolgenden Abtastintervallen jeweils mit einem rampen- oder dreieckförmigen Stromsignal angesteuert. Bei der direkten Absorptionsspektroskopie (DAS) kann die Konzentration der interessierenden Gaskomponente unmittelbar aus der an der Stelle der Absorptionslinie detektierten Minderung der Lichtintensität (Absorption) bestimmt werden. Bei der Wellenlängenmodulationsspektroskopie (WMS) wird während der vergleichsweise langsamen wellenlängenabhängigen Abtastung der Absorptionslinie zusätzlich die Wellenlänge des erzeugten Lichts mit hoher Frequenz und kleiner Amplitude sinusförmig moduliert. Das detektorseitig erhaltene Messignal wird üblicherweise bei einer n-ten Oberschwingung, vorzugsweise der zweiten Harmonischen, durch phasensensitive Lock-in Technik demoduliert und für jedes Abtastintervall zu einem die Konzentration der zu messenden Gaskomponente beinhaltenden Messergebnis ausgewertet (DE 10 2012 223 874 B3).

Wellenlängenmodulationsspektroskopie und Absorptionsspektroskopie haben spezifische Vor- und Nachteile. Die WMS ist insbesondere bei der Messung geringer Konzentrationen im Vorteil, weil sie Rauschen aus dem Messignal besser ausfiltern kann. Bei höheren Konzentrationen werden aber die für die WMS-Auswertung des Messignals notwendigen Näherungen zunehmend ungenau, wodurch der Messfehler steigt. Bei der DAS ist es umgekehrt; aufgrund der höheren Rauschempfindlichkeit ist der Messfehler bei kleinen Konzentrationen höher. Da aber keine Näherungsbeschreibung der Absorptionslinie notwendig ist, wird die Messgenauigkeit mit zunehmender Konzentration besser, weil das Nutzsignal stärker wird.

Durch das Rauschen, welches dem Messignal überlagert ist, wird die Nachweis- und Bestimmungsgrenze für die Messung der Konzentration der Gaskomponente begrenzt. Das Rauschen setzt sich hauptsächlich aus dem Rauschen des Gasanalysators auf der Laser- und der Detektorseite sowie dem Rauschen aus der Messstrecke (verursacht durch Turbulenzen, Partikel) zusammen.

Eine wesentliche Ursache für das Rauschen auf der Laserseite liegt in der Ansteuerung der Laserdiode, wenn z. B. der rampen- oder dreieckförmige Strom von einer steuerbaren Stromquelle erzeugt wird, die mittels einer zunächst digital erzeugten und danach in ein analoges Steuersignal umgesetzten Rampen- bzw. Dreieckfunktion angesteuert wird. Das WMS-Modulationssignal wird dann z. B. ebenfalls digital erzeugt, D/Agewandelt und dann dem analogen rampen- bzw. dreieckförmigen Steuersignal aufaddiert.

Der Erfindung liegt daher die Aufgabe zugrunde, das Rauschen bei der Ansteuerung der Laserdiode zu reduzieren, um so das Messignal-Rausch-Verhältnis des Gasanalysators zu verbessern.

Gemäß der Erfindung wird die Aufgabe durch den in Anspruch 1 definierten Gasanalysator gelöst, von dem vorteilhafte Weiterbildungen in den Unteransprüchen angegeben sind.

Gegenstand der Erfindung ist somit ein Gasanalysator zur Messung der Konzentration einer Gaskomponente in einem Messgas

- mit einer wellenlängenabstimmbaren Laserdiode, deren Licht nach Durchstrahlen des Messgases auf einen Detektor fällt, und
- mit einem Treiber, der die Laserdiode zur wellenlängenabhängigen Abtastung einer interessierenden Absorptionslinie der Gaskomponente mit einem periodischen rampenförmigen Strom ansteuert,

dadurch gekennzeichnet,

- dass der Treiber einen Kondensator enthält, der in Reihe mit einem steuerbaren Schalter an einer Spannungsquelle liegt und an dem parallel die Laserdiode in Reihe mit einem Vorwiderstand liegt, und
- dass der steuerbare Schalter steuerseitig an einem eine Impulsfolge erzeugenden Impulsgenerator angeschlossen ist.

Der steuerbare Schalter, bei dem es sich um einen einfachen Transistor handeln kann, wird bei jedem Impuls geschlossen, so dass der Kondensator aus der Spannungsquelle aufgeladen wird. Zwischen den Impulsen ist der steuerbare Schalter geöffnet bzw. ist der Transistor hochohmig, so dass der Kondensator über die Laserdiode und ihren Vorwiderstand entladen wird. Der die Laserdiode steuernde Strom kommt daher ausschließlich aus dem rauscharmen Kondensator. Aufgrund der exponentiellen Entladungskurve ist die Stromrampe nicht mehr konstant abfallend. Diese Krümmung kann jedoch bei der Auswertung berücksichtigt oder durch eine geeignete Zeitkonstante der Entladung reduziert werden.

Mittels eines in Reihe mit dem steuerbaren Schalter zwischen dem Kondensator und der Spannungsquelle liegenden weiteren Widerstands kann eine Zeitkonstante für die Aufladung des Kondensators festgelegt werden, so dass die Ladespannung des Kondensators zu Beginn seiner Entladung bzw. zu Beginn der Stromrampe auf einen Wert kleiner als die Versorgungsspannung der Spannungsquelle eingestellt und z. B. durch Variation der Impulsdauer und damit der Ladezeit variiert werden kann. Dadurch ist es möglich, die Amplitude der Stromrampe und ihren Bias einzustellen. Im Übrigen wird die Amplitude der Stromrampe von dem Vorwiderstand und dem Bahnwiderstand der Laserdiode und der Entladungs-Zeitkonstanten bestimmt, die wiederum von der Kapazität des Kondensators, dem Vorwiderstand und dem Bahnwiderstand der Laserdiode abhängig ist. Da der weitere Widerstand nicht im Entladestromkreis des Kondensators liegt, trägt er auch nicht zum Rauschen der Laserdiode bei.

Wenn die Konzentration der interessierenden Gaskomponente zusätzlich auf Basis der Wellenlängenmodulationsspektroskopie (WMS) bestimmt werden soll, kann ein Signalgenerator, der das sinusförmige analoge oder D/A-umgesetzte Modulationssignal erzeugt, auf einfache Weise ein über einen Koppelkondensator an der Laserdiode angeschlossen sein. Das Modulationssignal kann zusätzlich mittels eines LC- Tiefpassfilters schmalbandig vorgefiltert werden, um den Rauschbeitrag der WMS-Modulation zu minimieren. Alternativ kann das LC-Tiefpassfilter zusammen mit dem Vorwiderstand zwischen dem Kondensator und der Laserdiode angeordnet sein, um einen Einfluss des Modulationssignals auf die Erzeugung der Stromrampe zu verhindern. Zusätzlich können ein LC-Hochpassfilter oder ein Bandpassfilter zwischen der Laserdiode und der Modulationseinrichtung vorgesehen werden, um den Rauschbeitrag der WMS-Modulation zu minimieren. Durch eine gemeinsame Auswertung der durch DAS und WMS erhaltenen Signale kann das Rauschen noch weiter reduziert werden.

Im Weiteren wird die Erfindung anhand von Ausführungsbeispielen und unter Bezugnahme auf die Figuren der Zeichnung erläutert; im Einzelnen zeigen:

Fig. 1    ein Beispiel für den erfindungsgemäßen Gasanalysator,

Fig. 2    ein Beispiel einer Treiberschaltung für die Laserdiode und

Fig. 3    ein weiteres Beispiel der Treiberschaltung.

Gleiche Bezugszeichen haben in den verschiedenen Figuren die gleiche Bedeutung. Die Darstellungen sind rein schematisch und repräsentieren keine Größenverhältnisse.

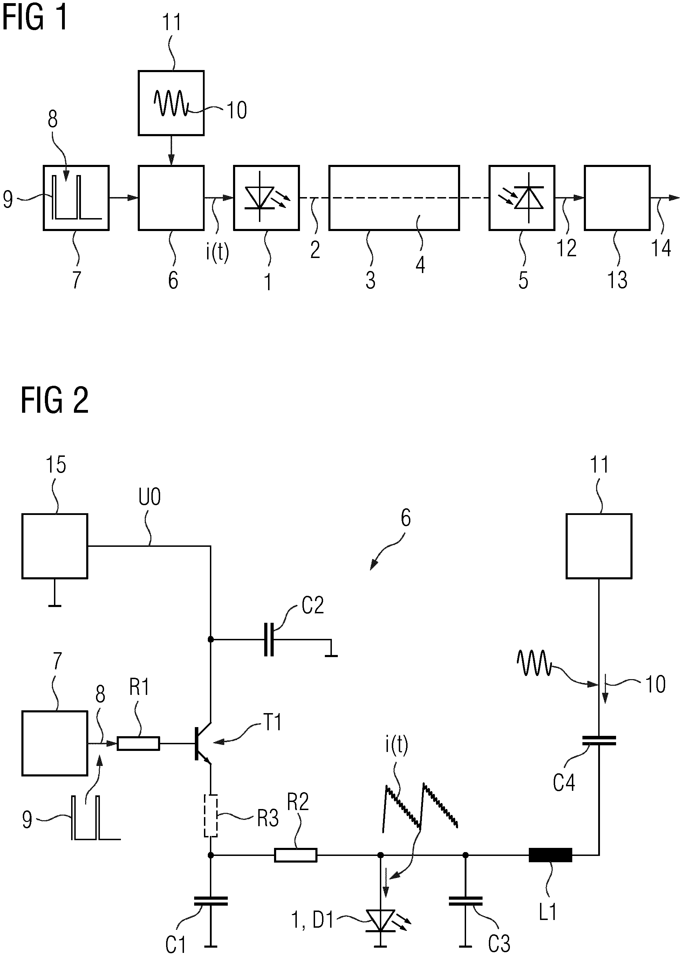

Fig. 1 zeigt in vereinfachter schematischer Darstellung das Blockschaltbild eines Gasanalysators mit einer Laserdiode 1, deren Licht 2 durch ein in einem Messvolumen 3, beispielsweise einer Gaszelle oder einer Prozessgasleitung, enthaltenes Messgas 4 auf einen Detektor 5 geführt ist. Die Laserdiode 1 wird von einem Treiber 6 mit einem Injektionsstrom i(t) angesteuert, wobei die Intensität und die Wellenlänge des erzeugten Lichts 2 von dem Strom i(t) und der Betriebstemperatur der Laserdiode 1 abhängen. Ein Impulsgenerator 7 erzeugt eine Impulsfolge 8 mit einer Frequenz von beispielsweise 100 Hz, zur Ansteuerung des Treibers 6, der den Strom i(t) zwischen zwei Impulsen 9 entsprechend einer rampenförmigen Funktion variiert, um mit der mehr oder weniger linear folgenden Wellenlänge des erzeugten Lichts 2 mindestens eine ausgewählte Absorptionslinie einer interessierenden Gaskomponente in dem Messgas 4 wellenlängenabhängig abzutasten.

Wenn die Konzentration der interessierenden Gaskomponente auch auf Basis der Wellenlängenmodulationsspektroskopie (WMS) bestimmt werden soll, kann die Stromrampe zusätzlich mit einem sinusförmigen Modulationssignal 10 hoher Frequenz, z. B. 40 KHz, moduliert werden, das von einem Signalgenerator 11 erzeugt wird.

Der Detektor 6 erzeugt in Abhängigkeit von der detektierten Lichtintensität ein Messsignal 12, das in einer Signalverarbeitungs- und -auswerteeinrichtung 13 in an sich bekannter Weise auf Basis der direkten Absorptionsspektroskopie (DAS) und ggf. der Wellenlängenmodulationsspektroskopie (WMS) zu einem Messergebnis 14 der Konzentration der interessierenden Gaskomponente ausgewertet wird.

Fig. 2 zeigt ein Schaltungsbeispiel des Treibers 6 für die Laserdiode 1, die als Schaltungsbauelement im Folgenden mit D1 bezeichnet wird. Der Treiber 6 enthält einen Kondensator C1, der in Reihe mit einem steuerbaren Schalter T1 in Form eines Transistors an einer Spannungsquelle 15 mit einer Versorgungsspannung UO gegen Masse liegt. Parallel zu der Spannungsquelle 15 kann ein Stützkondensator C2 angeordnet sein. Die Laserdiode D1 liegt in Reihe mit einem Vorwiderstand R2 parallel an dem Kondensator C1. Der Transistor T1 ist an seiner Basis über einen Basisvorwiderstand R1 an dem die Impulsfolge 8 erzeugenden Impulsgenerator 7 angeschlossen.

Bei jedem Impuls 8 wird der Transistor T1 leitend geschaltet, so dass der Kondensator C1 während der kurzen Impulsdauer auf die Spannung UO aufgeladen wird. Soll die Ladespannung geringer als UO sein, kann zwischen dem Transistor T1 und dem Kondensator C1 oder zwischen dem Transistor T1 und dem die Versorgungsspannung UO führenden Anschluss der Spannungsquelle 15 ein weiterer Widerstand R3 angeordnet werden, wobei durch Verkürzen der Impulsdauer die am Ende des Impulses erreichbare Ladespannung des Kondensators C1 variierbar ist.

In den Impulspausen zwischen den Impulsen 9 ist der Transistor T1 hochohmig, so dass der Kondensator C1 über den Vorwiderstand R2 und die Laserdiode D1 entladen wird. Für den Verlauf des Stromes i(t) gilt somit:

$$i(t) = (U - U_F)/(R_B + R2) \cdot \exp(-t/((R_B + R2) \cdot C1),$$

wobei U die Ladespannung des Kondensators C1, $U_F$ die Flussspannung der Laserdiode D1 und $R_B$ den Bahnwiderstand der Laserdiode D1 bezeichnen. Um zu erreichen, dass die Spannung an dem Kondensator C1 und damit der Strom i(t) durch die Laserdiode D1 annähernd linear abfallen, kann die Entlade-Zeitkonstante $(R_B + R2) \cdot C1$ so gewählt werden, dass sie z. B. etwa das das 5-fache der Impulspause beträgt.

Wie aus der oben angegebenen Gleichung für i(t) ersichtlich, können die Amplitude und der Bias der Stromrampe über die Ladespannung U des Kondensators C1 variiert werden.

Um die Konzentration der interessierenden Gaskomponente zusätzlich auf Basis der Wellenlängenmodulationsspektroskopie (WMS) bestimmt zu können, kann das Modulationssignal 10 des Signalgenerators 11 über einen Koppelkondensator C4 der Laserdiode D1 zugeführt werden. Die Kapazität des Koppelkondensators C4 ist im Vergleich zu der des Kondensators C1 sehr gering und beträgt z. B. 1 nF gegenüber 470 µF des Kondensators C1. Bei dem gezeigten Ausführungsbeispiel ist zusätzlich ein LC-Tiefpassfilters L1, C3 vorhanden, um das Modulationssignal 10 vorzufiltern und so den Rauschbeitrag der WMS-Modulation zu minimieren.

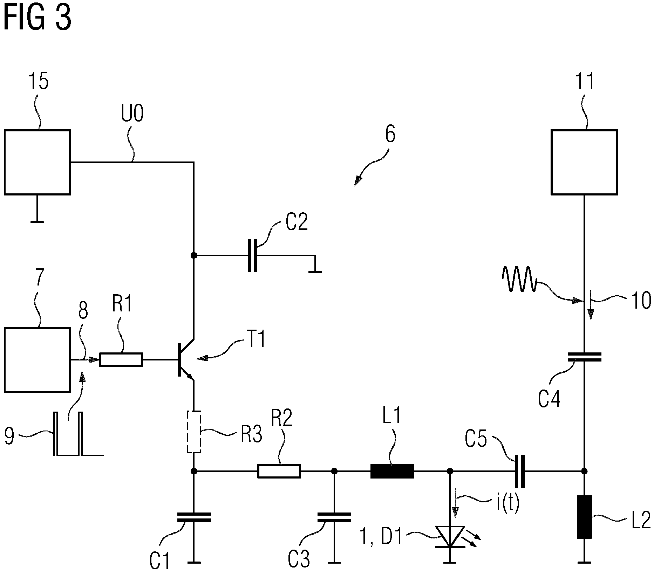

Fig. 3 zeigt ein weiteres Schaltungsbeispiel des Treibers 6, das sich von dem nach Fig. 2 dadurch unterscheidet, dass das LC-Tiefpassfilter L1, C3 im Strompfad des Stromes i(t) zwischen dem Kondensator C1 und der Laserdiode D1 angeordnet ist. Dadurch kann verhindert werden, dass das Modulationssignal bzw. der Modulationsstrom 10 über R3 und C1 abfließt und sich störend auf die Erzeugung der Stromrampe i (t) auswirkt. Umgekehrt verhindert der Koppelkondensator C4 ein Abfließen des rampenförmigen Stroms i(t) über den Signalgenerator 11. Wie gezeigt, kann zusätzlich ein LC-Hochpassfilter C5, L2 oder ein Bandpassfilter (nicht gezeigt) zwischen der Laserdiode D1 und der Modulationseinrichtung 11 vorgesehen werden, um den Rauschbeitrag der WMS-Modulation zu minimieren.

Der Treiber 6 für die Laserdiode 1 weist insbesondere folgende Vorteile auf:

Da als resistive Schaltungsbauelemente nur der Vorwiderstand R2 und ggf. der weitere Widerstand R3 vorgesehen sind, ist die Verlustleistung Treibers 6 sehr gering, so dass im Unterschied zu bekannten Lasertreibern kaum Kühlung erforderlich ist.

Da die Stromrampe durch Entladung eines Kondensators erzeugt wird und keine Analog-/Digital-Umsetzer, Operationsverstärker etc. vorhanden sind, erfolgt die Ansteuerung der Laserdiode D1 für die direkten Absorptionsspektroskopie (DAS) sehr rauscharm.

**Patentansprüche**

1. Gasanalysator zur Messung der Konzentration einer Gaskomponente in einem Messgas (5)

    - mit einer wellenlängenabstimmbaren Laserdiode (1), deren Licht (2) nach Durchstrahlen des Messgases (4) auf einen Detektor (5) fällt, und
    - mit einem Treiber (6), der die Laserdiode (1) zur wellenlängenabhängigen Abtastung einer interessierenden Absorptionslinie der Gaskomponente mit einem periodischen rampenförmigen Strom (i) ansteuert,

    **dadurch gekennzeichnet,**

    - **dass** der Treiber (6) einen Kondensator (C1) enthält, der in Reihe mit einem steuerbaren Schalter (T1) an einer Spannungsquelle (15) liegt und an dem parallel die Laserdiode (1) in Reihe mit einem Vorwiderstand (R2) liegt, und
    - **dass** der steuerbare Schalter (T1) steuerseitig an einem eine Impulsfolge (8) erzeugenden Impulsgenerator (7) angeschlossen ist.

2. Gasanalysator nach Anspruch 1, **dadurch gekennzeichnet, dass** der steuerbare Schalter (T1) in Reihe mit einem weiteren Widerstand (R3) zwischen dem Kondensator (C1) und der Spannungsquelle (15) liegt.

3. Gasanalysator nach Anspruch 1 oder 2, **dadurch gekennzeichnet, dass** zur Wellenlängenmodulation der Lichts (2) ein ein sinusförmiges Modulationssignal (10) erzeugender Signalgenerator (11) über einen Koppelkondensator (C4) an der Laserdiode (1) angeschlossen ist.

4. Gasanalysator nach Anspruch 3, **dadurch gekennzeichnet, dass** der Signalgenerator (11) über den Koppelkondensator (C4) und ein LC-Tiefpassfilter (L1, C3) an der Laserdiode (1) angeschlossen ist.

5. Gasanalysator nach Anspruch 3, **dadurch gekennzeichnet, dass** zwischen dem Kondensator (C1) und der Laserdiode (1) zusätzlich ein LC-Tiefpassfilter (L1, C3) liegt.

6. Gasanalysator nach Anspruch 5, **dadurch gekennzeichnet, dass** der Signalgenerator (11) über den Koppelkondensator (C4) und ein LC-Hochpassfilter (C5, L2) oder ein Bandpassfilter an der Laserdiode (1) angeschlossen ist.

## FIG 1

## FIG 2

FIG 3

Europäisches Patentamt
European Patent Office
Office européen des brevets

## EUROPÄISCHER RECHERCHENBERICHT

Nummer der Anmeldung

EP 19 19 9255

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | M. FISCHER ET AL: "Intermittent operation of QC-lasers for mid-IR spectroscopy with low heat dissipation: tuning characteristics and driving electronics", OPTICS EXPRESS, Bd. 22, Nr. 6, 24. März 2014 (2014-03-24), Seite 7014, XP055684491, US ISSN: 2161-2072, DOI: 10.1364/OE.22.007014 | 1,2 | INV. G01N21/39 G01N21/3504 G01J3/433 H01S5/042 |
| Y | * Zusammenfassung; Abschnitt 3. Analog driver for intermittent scanning operation; Fig. 3, 5, 6, 10 * | 3-6 | |
| X | LIU CHANG ET AL: "Laser driving and data processing concept for mobile trace gas sensing: Design and implementation", REVIEW OF SCIENTIFIC INSTRUMENTS, AIP, MELVILLE, NY, US, Bd. 89, Nr. 6, 11. Juni 2018 (2018-06-11), XP012229119, ISSN: 0034-6748, DOI: 10.1063/1.5026546 [gefunden am 2018-06-11] | 1,2 | |
| Y | * Zusammenfassung; Abschnitt II. Laser Driving and Data Processing Considerations; Abschnitt III. Hardware Development; Fig. 5 * | 3-6 | RECHERCHIERTE SACHGEBIETE (IPC) G01J G01N H01S |
| Y | US 6 351 309 B1 (BOMSE DAVID S [US] ET AL) 26. Februar 2002 (2002-02-26) * Spalte 5, Zeile 35 - Spalte 9, Zeile 38; Fig. 2 * | 3 | |
| Y | US 5 202 570 A (TANAKA HIROAKI [US] ET AL) 13. April 1993 (1993-04-13) * Spalte 2, Zeilen 1 - 30; Spalte 7, Zeile 65 - Spalte 8, Zeile 4; Fig. 5 * | 3-6 | |

-/--

Der vorliegende Recherchenbericht wurde für alle Patentansprüche erstellt

| Recherchenort | Abschlußdatum der Recherche | Prüfer |
|---|---|---|
| München | 14. April 2020 | Flentje, Farida |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
............................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 19 19 9255

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 5 047 639 A (WONG JACOB Y [US]) 10. September 1991 (1991-09-10) * Spalte 3, Zeilen 30 - 46; Spalte 6, Zeilen 27 - 38; Fig. 4 * ----- | 3 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 14. April 2020 | Flentje, Farida |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 19 9255

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-04-2020

| Im Recherchenbericht angeführtes Patentdokument | Datum der Veröffentlichung | Mitglied(er) der Patentfamilie | | Datum der Veröffentlichung |
|---|---|---|---|---|
| US 6351309 B1 | 26-02-2002 | KEINE | | |
| US 5202570 A | 13-04-1993 | CA | 2038980 A1 | 28-09-1991 |
| | | EP | 0449573 A2 | 02-10-1991 |
| | | US | 5202570 A | 13-04-1993 |
| US 5047639 A | 10-09-1991 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012223874 B3